(19) Europäisches Patentamt
European Patent Office
Office européen des brevets

(11) **EP 3 143 694 B1**

(12) **FASCICULE DE BREVET EUROPEEN**

(45) Date de publication et mention
de la délivrance du brevet:
**13.06.2018 Bulletin 2018/24**

(51) Int Cl.:
***H03K 3/38*** *(2006.01)*    ***H03K 19/195*** *(2006.01)*

(21) Numéro de dépôt: **15723494.9**

(22) Date de dépôt: **15.05.2015**

(86) Numéro de dépôt international:
**PCT/EP2015/060778**

(87) Numéro de publication internationale:
**WO 2015/173403 (19.11.2015 Gazette 2015/46)**

(54) **CIRCUIT LOGIQUE À BASE DE VANNES DE SPIN DU TYPE À SUPERCOURANT POLARISÉ EN SPIN ET CIRCUIT INTÉGRANT DE TELLES PORTES LOGIQUES**

SPINTRONIC LOGIKSCHALTUNG MIT SPIN POLARISIERTEM STROMSCHALTER UND INTEGRIERTER SCHALTUNG

SPINTRONIC CIRCUIT WITH SPIN POLARIZED CURRENT SWITCH AND SEMICONDUCTOR DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.05.2014 FR 1401093**

(43) Date de publication de la demande:
**22.03.2017 Bulletin 2017/12**

(73) Titulaires:
• **THALES**
**92400 Courbevoie (FR)**
• **Centre National de la Recherche Scientifique (C.N.R.S.)**
**75016 Paris (FR)**

(72) Inventeurs:
• **VILLEGAS, Javier**
**F-92140 Clamart (FR)**
• **CRETE, Denis**
**F-91767 Palaiseau Cedex (FR)**

(74) Mandataire: **Lavoix**
**2, place d'Estienne d'Orves**
**75441 Paris Cedex 09 (FR)**

(56) Documents cités:
**GB-A- 2 445 377**

• **SOULEN R J ET AL: "Andreev reflection: A new means to determine the spin polarization of ferromagnetic materials", JOURNAL OF APPLIED PHYSICS, AMERICAN INSTITUTE OF PHYSICS, US, vol. 85, no. 8, 15 avril 1999 (1999-04-15) , pages 4589-4591, XP012047191, ISSN: 0021-8979, DOI: 10.1063/1.370417**
• **KLAPWIJK T M: "Proximity Effect From an Andreev Perspective", JOURNAL OF SUPERCONDUCTIVITY: INCORPORATING NOVEL MAGNETISM, KLUWER ACADEMIC PUBLISHERS-PLENUM PUBLISHERS, NE, vol. 17, no. 5, 1 octobre 2004 (2004-10-01), pages 593-611, XP019285140, ISSN: 1572-9605 cité dans la demande**

**Description**

La présente invention est relative à des portes logiques mettant en oeuvre des vannes de spin du type à supercourant polarisé en spin.

La technologie des portes logiques à base de composants électroniques (fondés sur la circulation de charges électriques) a atteint ses limites en termes de capacité, vitesse, fonctionnalité, etc.

En revanche, le domaine des composants spintroniques (fondés sur la circulation de spin comme décrit par SOULEN R J ET AL: "Andreev reflection: A new means to determine the spin polarization of ferromagnetic materials",JOURNAL OF APPLIED PHYSICS, AMERICAN INSTITUTE OF PHYSICS, US, vol. 85, no. 8, 15 avril 1999 (1999-04-15), pages 4589-4591) est prometteur. Cependant, différents problèmes généraux se posent.

Le premier problème est de trouver des matériaux qui permettent à l'information portée par le spin des électrons de voyager sans perturbation sur des distances suffisamment longues, notamment pour pouvoir construire des circuits logiques avec plusieurs ports d'entrée et/ou de sortie.

Le second problème consiste à maximiser le rapport entre le signal haut correspondant au bit +1 (OFF) et le signal bas correspondant au bit 0 (ON), dit rapport ON/OFF dans ce qui suit.

Enfin, le troisième problème correspond à la réduction de l'effet Joule de dissipation sous forme de chaleur des courants d'électrons porteurs de l'information de spin.

Le signal de spin étant exponentiellement décroissant sur une longueur caractéristique dite de diffusion de spin, ISF, la distance sur laquelle la polarisation du spin électronique est conservée est extrêmement courte.

Cette distance de conservation de la polarisation limite le rapport ON/OFF.

Une stratégie pour maximiser les signaux de spin consiste alors à réaliser des dispositifs aussi petits que possibles par rapport à la longueur caractéristique ISF. Il est à noter que toutes les dimensions du dispositif, même dans les directions perpendiculaires à la circulation du courant de spin, doivent être petites par rapport à la longueur ISF, pour éviter la diffusion des spins latéralement, et conserver ainsi le signal de spin. Cependant, la réduction de la section transversale provoque une augmentation de l'effet Joule.

Une autre stratégie pour améliorer les dispositifs de spintronique consiste à rechercher des matériaux dans lesquels la longueur ISF est longue.

Cependant, la longueur ISF est rarement supérieure à quelques dixièmes de nanomètres dans les métaux. Les matériaux avec une longueur ISF plus importante, tels que les semi-conducteurs (ISF de quelques centaines de nanomètres) ou le graphène (ISF de quelques microns) sont beaucoup plus résistifs.

Par ailleurs, l'article SOULEN R.J. et al, "Andreev reflection: A new means to determine the spin polarization of ferromagnetic materials", JOURNAL OF APPLIED PHYSICS, AMERICAN INSTITUTE OF PHYSICS, US, vol. 85, no. 8, 15 avril 1999 (1999-04-15), pages 4589-4591, XP012047191, ISSN: 0021-8979, décrit un système pour mesurer la polarisation du spin utilisant l'effet Andreev pour un module avec une couche supraconductrice en surface avec un couche intermédiaire.

L'invention a pour but de pallier ce problème.

Pour cela l'invention a pour objet un circuit caractérisé en ce qu'il comporte :

- une couche intermédiaire, constituée d'un matériau conducteur du courant électrique et conformée selon un motif ;
- une première électrode et une pluralité d'électrodes, qui comporte au moins des seconde et troisième électrodes ;

chaque électrode comportant :

◦ Un polariseur, en un matériau ferromagnétique, placé en un point particulier du motif de la couche intermédiaire, et présentant une magnétisation,
◦ Une couche supraconductrice, en un matériau supraconducteur, disposée sur une surface du polariseur opposée à une surface du polariseur en contact avec la couche intermédiaire ;

- au moins un moyen de commande propre à modifier la magnétisation du polariseur d'une électrode parmi les seconde et troisième électrodes ;
- au moins un autre moyen de commande propre à modifier la magnétisation du polariseur de l'autre électrode parmi les seconde et troisième électrodes ;

les première et seconde électrodes, d'une part, et les première et troisième électrodes, d'autre part, constituant deux vannes de spin du type à supercourant polarisé en spin,

- des bornes de biais d'application d'un signal de biais; et,
- des bornes de mesure d'un signal de sortie,

un niveau du signal de sortie étant corrélé à une orientation des première, seconde et troisième magnétisations entre elles.

Suivant des modes particuliers de réalisation, le composant comporte une ou plusieurs des caractéristiques suivantes, prise(s) isolément ou suivant toutes les combinaisons techniquement possibles :

- le motif étant une bande, les première, seconde et troisième électrodes sont disposées successivement selon la longueur de ladite bande, en ménageant un espace entre elles, et les bornes de mesure sont disposées aux extrémités de la bande, de part et d'autre des électrodes, le niveau du signal de sortie correspondant alors à un « OU » logique entre les magnétisations des seconde et troisième électrodes, la première magnétisation étant fixe, ou le complémentaire d'une « EQV » logique entre les magnétisations des première, seconde et troisième électrodes ;
- les première et troisième électrodes portent chacune une borne de biais pour l'application du signal de biais, qui est un courant, et le signal de sortie est une tension mesurée entre les bornes de mesure ;
- le motif comporte :

  ◦ - des portions amont et aval constituées chacune par une bande qui est en contact électrique avec l'une des bornes de mesure ; et,
  ◦ - une portion intermédiaire constituée par une bande en forme de boucle définissant une branche supérieure et une branche inférieure,

  la première électrode étant placée sur la portion amont, la seconde électrode, sur la branche inférieure et la troisième électrode, sur la branche supérieure, un niveau du signal de sortie pris entre les bornes de mesure situées aux extrémités du motif correspond à un « ET » logique entre les magnétisations des seconde et troisième électrodes ;
- le motif comporte :

  ◦ - des portions amont et aval constituées chacune par une bande qui est en contact électrique avec l'une des bornes de mesure, une première électrode étant placée sur la portion amont en aval de la borne de mesure, une aimantation de la première électrode correspondant à un niveau logique C ; et,
  ◦ - une portion intermédiaire constituée par la mise en parallèle électrique de plusieurs bandes définissant chacune des branches, chaque branche étant identifiée par un entier k, étant connectée d'une part à la portion amont et d'autre part à la portion aval et portant une électrode, dont une aimantation correspondant à un niveau logique Vk,

  un niveau du signal de sortie pris entre les bornes de mesure situées aux extrémités du motif correspond à une fonction logique $NOR(V_k==C)$ entre les magnétisations des électrodes ;
- le signal de sortie est une tension mesurée entre les bornes de mesure, et un courant de polarisation est appliqué entre les bornes de biais (I+, I-), dont une première borne de biais fait partie de la portion amont, en amont de la première électrode, et dont une seconde borne de biais fait partie de la portion aval du circuit, en aval des électrodes ;
- la couche intermédiaire étant interrompue par une découpe, le signal de sortie est un courant traversant une résistance connectant la couche intermédiaire de part et d'autre de la découpe, et la source de polarisation étant une tension de biais appliquée entre les bornes de biais situées à chacune des extrémité du motif ;
- le matériau supraconducteur des couches supraconductrices de chaque électrode est un matériau supraconducteur à haute température critique, de préférence du YBCO;
- une épaisseur des couches supraconductrices de chaque électrode est choisie entre 20 et 40 nm, de préférence 25 et 35 nm, de préférence encore égale à 30 nm ;
- le matériau ferromagnétique des polariseurs de chaque électrode est du LCMO ;
- une épaisseur des polariseurs de chaque électrode est choisie entre 3 et 10 nm, de préférence égale à 5 nm ;
- le matériau de la couche intermédiaire est un métal normal, choisi parmi les oxydes de métal normal ou les métaux normaux élémentaires ;
- une épaisseur de la couche intermédiaire est choisie entre 15 et 25 nm, de préférence égale à 20 nm ;
- le substrat est réalisé en un matériau choisi parmi le saphir et le $SrTiO_3$ ;
- une distance entre les électrodes et une épaisseur des polariseurs des électrodes dépend d'une longueur de cohérence des porteurs de charge dans la couche intermédiaire et d'une longueur de cohérence des porteurs de charge dans les polariseurs ; et
- chaque porte logique étant conforme à une porte selon l'une quelconque des portes logiques précédentes.

L'invention et ses avantages seront mieux compris à la lecture de la description qui va suivre, donnée uniquement à titre d'exemple illustratif et non limitatif, et faite en se référant aux dessins annexés sur lesquels :

- la figure 1 est un graphe courant-tension générique d'un composant électronique du type à jonction Josephson ;
- la figure 2 est une représentation schématique d'un premier mode de réalisation d'un composant électronique à jonction Josephson;
- les figure 3 et 4 sont des représentations schématiques d'un second mode de réalisation d'un composant électronique à jonction Josephson;
- la figure 5 est une représentation schématique d'un troisième mode de réalisation d'un composant électronique à jonction Josephson ;
- la figure 6 représente schématiquement un circuit logique constituant une porte logique « OU » à base de vannes de spin ;
- la figure 7a représente schématiquement un circuit logique « ET » à base de vannes de spin ;
- la figure 7b représente une variante de réalisation du circuit logique de la figure 7a;
- la figure 8 représente une variante de réalisation du circuit logique de la figure 7a;
- la figure 9 représente une variante de réalisation du circuit logique de la figure 8 ; et
- les figures 10 et 11 représentent deux manières de placer en cascade les circuits logiques dans un circuit électronique.

Le circuit logique selon l'invention met en oeuvre un composant spintronique utilisant des courants supraconducteurs à polarisation de spin.

Après une présentation de tels composants spintroniques, différents modes de réalisation de circuits logiques seront présentés.

Le composant spintronique met en oeuvre une jonction Josephson.

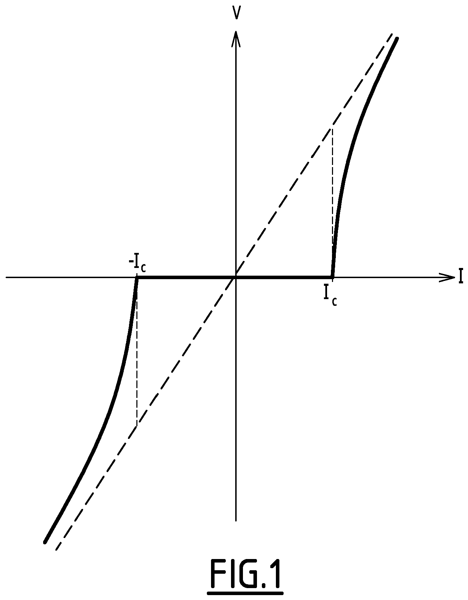

Une telle jonction Josephson va maintenant être présentée de manière générale par référence à la figure 1.

De manière connue, une jonction Josephson comporte des première et seconde couches en un matériau supraconducteur, séparées l'une de l'autre par une couche intermédiaire en un matériau non-supraconducteur.

Dans un milieu supraconducteur, les porteurs de charge sont constitués, d'une part, par des électrons normaux, et, d'autre part, par l'association de deux électrons, au sein d'une paire de Cooper. Dans les supraconducteurs dits « conventionnels », les électrons associés présentent des spins opposés, la paire de Cooper possédant alors un spin nul. La statistique suivie par un gaz de paires de Cooper est une statistique de Bose-Einstein, selon laquelle plusieurs paires de Cooper peuvent occuper simultanément le même état quantique. En particulier, à une température inférieure à une température critique, toutes les paires de Cooper se condensent dans le même état quantique fondamental.

De ce fait, le gaz de porteurs de charge est décrit macroscopiquement par une fonction d'onde quantique à valeur complexe. Celle-ci présente une phase $\theta$.

Dans une jonction Josephson, bien que la continuité du matériau supraconducteur soit interrompue par la présence du matériau non-supraconducteur de la couche intermédiaire, il existe un couplage entre les fonctions d'onde des porteurs de charge dans les première et seconde couches supraconductrices.

En effet, selon l'effet Josephson, la fonction d'onde des porteurs de charge de la première couche supraconductrice s'étend à travers la couche intermédiaire, jusque dans la seconde couche supraconductrice où elle interfère avec la fonction d'onde des porteurs de charge de la seconde couche supraconductrice.

La caractéristique courant - tension d'une jonction Josephson, dont le matériau intermédiaire est un métal, est représentée de manière schématique à la figure 1.

On montre que le courant $I$ et la tension V prennent la forme paramétrique suivante :

$$I = \frac{\Phi_0}{2\pi R}\frac{d\varphi}{dt} + I_c \sin\varphi \qquad (1)$$

$$V = \frac{\Phi_0}{2\pi}\frac{d\varphi}{dt} \qquad (2)$$

Où

- Le paramètre $\varphi = \theta_1 - \theta_2$ correspond à la différence entre les phases des fonctions d'ondes des porteurs de charge dans les première et seconde couches supraconductrices, respectivement ;
- $\Phi_0$ est une constante caractéristique de l'effet Josephson et s'exprime en fonction de la constante de Planck $\underline{h}$ et

$$\Phi_0 = \frac{h}{2e} \; ;$$

de la charge de l'électron $\underline{e}$ selon :
- R est dénommée résistance normale et correspondant à la pente des branches asymptotiques de la caractéristique courant - tension ;
- t représente le temps ; et,

- $I_c$ est un courant critique, caractéristique de la jonction Josephson.

Il existe une solution pour laquelle la différence de phase φ est constante dans le temps. La tension *V* est nulle, mais un courant continu peut être mis en circulation à travers la jonction Josephson. Ce courant continu est inférieur à $I_c$, à cause du terme en *sinφ* dans la relation (1).

Il existe également une solution pour laquelle la tension *V* est constante et non nulle. La différence de phase est alors une fonction monotone croissante en fonction du temps. Un courant oscillant en sinφ traverse la jonction Josephson.

On notera, sans rentrer dans les détails, que le paramètre caractéristique $I_c$ est une fonction de la composante du champ magnétique dans un plan transverse à la direction d'empilement des couches de la jonction Josephson.

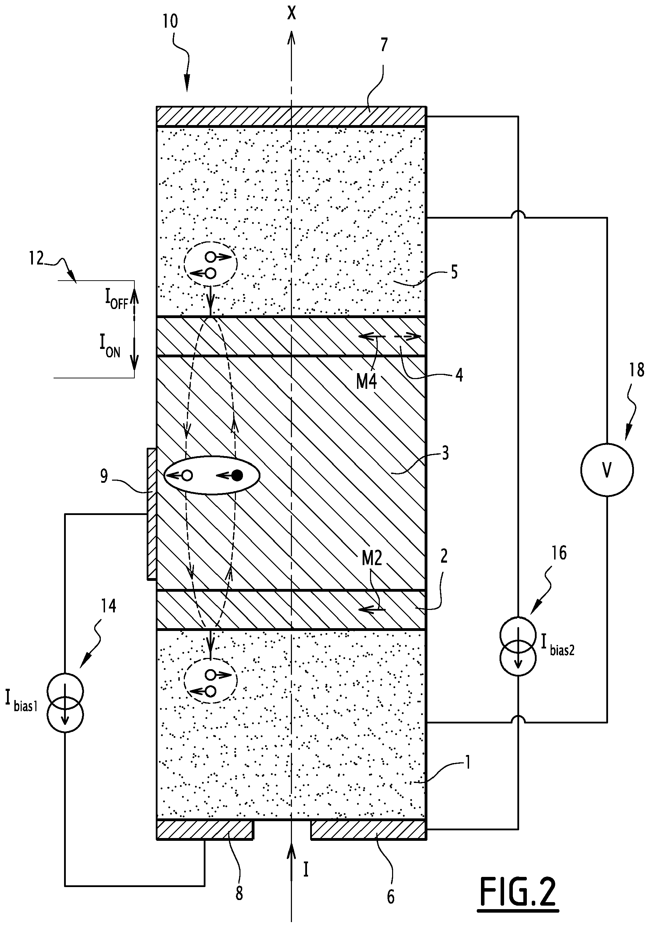

En se référant maintenant à la figure 2, un premier mode de réalisation d'un composant spintronique à jonction Josephson va être présenté.

Selon ce premier mode de réalisation, le composant 10 résulte de l'empilement, selon une direction d'empilement X, d'une première couche 1, d'un premier polariseur 2, d'une couche intermédiaire 3, d'un second polariseur 4, et d'une seconde couche 5.

Les première et seconde couches, 1 et 5, sont réalisées en un matériau supraconducteur. Il s'agit de préférence d'un matériau supraconducteur à haute température critique, c'est-à-dire exhibant des propriétés de supraconduction pour des températures dans la gamme de 25 à 120 K. Il s'agit par exemple d'un oxyde mixte de baryum de cuivre et d'yttrium, dénommé YBCO. L'oxyde $YBa_2Cu_3O_7$ est de préférence utilisé.

Une épaisseur des première et seconde couches, 1 et 5, peut être choisie a priori arbitrairement. Cependant, l'épaisseur minimale dépend du matériau utilisé. Pour l'YBCO, l'épaisseur des première et seconde couches est choisie entre 5 et 50 nm, de préférence entre 20 et 40 nm, de préférence encore égale à 30 nm.

La couche intermédiaire 3 est en matériau conducteur du courant électrique. Le matériau de la couche intermédiaire est choisi par exemple parmi les oxydes complexes, tel que l'oxyde de $LaNiO_3$, les métaux normaux élémentaires, tels que le cuivre Cu, l'argent Ag, l'or Au, etc., ou encore les semiconducteurs.

Une épaisseur de la couche intermédiaire 3 devra être inférieure à une longueur $L_N$ dite longueur de cohérence dans le matériau conducteur, qui dépend du matériau effectivement utilisé pour la couche intermédiaire. Par exemple, pour $LaNiO_3$, l'épaisseur est choisie entre 0,1 et 100 nm, de préférence la plus courte possible, par exemple égale à 20 nm.

Les premier et second polariseurs, 2 et 4, sont en un matériau conducteur ferromagnétique. Ce matériau ferromagnétique est de préférence un oxyde de manganite de lanthane calcium, dénommé LCMO selon l'acronyme anglais correspondant. Un milieu ferromagnétique répondant à la formule $La_{0,7}Ca_{0,3}MnO_3$ est de préférence utilisé.

Le premier polariseur 2 présente une première magnétisation M2 selon une première direction de magnétisation. Dans un exemple de réalisation simple, la première magnétisation M2 est constante en sens et en intensité au cours de l'utilisation du composant et est perpendiculaire à la direction d'empilement.

Le second polariseur 4 présente une seconde magnétisation M4. Dans un exemple de réalisation simple, l'intensité de la seconde magnétisation M4 est approximativement constante, mais sa direction et son sens par rapport à la première direction de magnétisation varient au cours de l'utilisation du composant. Dans un mode de réalisation simple, seulement le sens de la magnétisation M4 varie selon la première direction de magnétisation, qui est constante.

Les épaisseurs des premier et second polariseurs, 2 et 4, sont choisies inférieures à une longueur de cohérence $L_P$ dans le matériau ferromagnétique. Dans le cas du LCMO, l'épaisseur est de préférence entre 0,1 et 100 nm, de préférence égale à 5 nm.

Le principe physique mis en oeuvre dans le présent composant est l'effet Andreev (ou réflexion d'Andreev). Cet effet est connu et présenté par exemple dans l'article T.M. Klapwijk, « Proximity effect from an Andreev perspective », Journal of Superconductivity: Incorporating Novel Magnetism, Vol. 17, No. 5, October 2004.

Cet effet a lieu à l'interface entre un milieu conducteur et un milieu supraconducteur.

Selon cet effet, un électron se déplaçant dans le milieu conducteur et incident sur l'interface avec le milieu supraconducteur peut conduire à la transmission d'une paire de Cooper dans le supraconducteur et à la réflexion d'un trou dans le milieu conducteur.

La conservation de l'impulsion impose que, si l'électron possède une impulsion p (vectorielle), la paire de Cooper possèdera une impulsion 2.p et le trou, une impulsion -p.

Si l'électron possède un spin s, le trou possède soit un spin -s (la paire électron-trou constituant alors un singulet dont le spin total est nul), soit un spin s (la paire électron-trou occupant un niveau triple dont le spin total est égal à l'unité).

Dans le premier cas, un supercourant dit conventionnel est généré à travers l'interface. Le supercourant conventionnel transporte une charge mais pas de spin.

Dans le second cas, un supercourant dit non conventionnel est généré à travers l'interface. Cela nécessite un processus dit de « renversement du spin » (« spin-flip » en anglais) à l'interface entre le milieu supraconducteur et le milieu conducteur, qui est présent notamment quand le milieu conducteur est un milieu ferromagnétique (par exemple du LCMO). Le supercourant non conventionnel transporte ainsi une charge et un spin.

Il résulte de cet effet que la fonction d'onde des paires électron/trou dans le milieu conducteur est couplée, au niveau de l'interface, avec la fonction d'onde des paires de Cooper du milieu supraconducteur.

Puisque le supercourant non conventionnel est polarisé en spin, il est sensible aux effets de polarisation à l'interface entre le milieu conducteur et le milieu supraconducteur. La présence d'un polariseur (présentant une magnétisation déterminée) à l'interface entre le milieu conducteur et le milieu supraconducteur permet de sélectionner, parmi les électrons ou les trous incidents, les électrons ou les trous dont le spin est parallèle à la magnétisation du polariseur et, par conséquent, ceux qui peuvent effectivement participer à la circulation d'un supercourant non conventionnel à travers l'interface.

Dans le composant présenté ci-dessus, un polariseur 2, respectivement 4, est prévu à l'interface entre la couche intermédiaire 3 et la couche supraconductrice 1, respectivement 5, de manière à contrôler les supercourants non conventionnels à chaque interface.

De plus, les paires électron/trou générées à une interface peuvent circuler dans la couche intermédiaire 3. Par exemple, une paire électron/trou générée à l'interface entre la couche intermédiaire 3 et la seconde couche supraconductrice 5 portant un supercourant non conventionnel, peut circuler à travers la couche intermédiaire 3 jusqu'à l'interface entre la couche intermédiaire 3 et la première couche supraconductrice 1 pour participer à un supercourant non conventionnel au niveau de cette interface.

De ce fait, il existe des états liés entre les paires électron/trou dans la couche intermédiaire et les paires de Cooper dans la première couche supraconductrice 1 et dans la seconde couche supraconductrice 5. Il y a donc interaction entre les fonctions d'ondes des porteurs de charge des première et deuxième couches supraconductrices, via un mécanisme de génération et transmission de paires électron/trou à travers la couche intermédiaire.

Pour introduire effectivement un couplage entre les fonctions d'onde des première et seconde couches supraconductrices entre elles, les épaisseurs des couches ferromagnétiques 2 et 4 et de la couche intermédiaire 3 sont choisies en fonction de la longueur de cohérence $L_P$ des paires électron/trou dans le matériau ferromagnétique et de la longueur de cohérence $L_N$ des paires électron/trou dans le matériau intermédiaire. Par exemple, la longueur de cohérence la plus petite entre ces deux longueurs est choisie comme contrainte.

De manière générale, pour un matériau la longueur de cohérence s'écrit : $l_i = \frac{\hbar v_{Fi}}{2\pi KT}$ dans le régime balistique, ou $l_i = \sqrt{\frac{\hbar D_i}{2\pi KT}}$ dans le régime diffusif. Où

- $T$ est la température absolue ;
- $K$ est la constante de Boltzmann ;
- $\hbar$ est la constante de Planck réduite ;
- $v_{Fi}$ est la vitesse de Fermi dans le matériau $i$ ; et,
- $D_i$ est la constante de diffusion électronique dans le matériau $i$.

Les mesures de la longueur de cohérence $L_P$ montrent qu'elle est supérieure à 30 nm dans le LCMO.

Compte tenu de la vitesse de Fermi $v_{FN}$ qui vaut environ $10^5$ m/s dans le $LaNiO_3$, la longueur de cohérence $L_N$ est plus longue dans ce matériau que la longueur $L_P$ (et ceci d'autant plus que le matériau conducteur est porté à basse température), et encore plus longue dans des métaux tels que Au ou Ag.

En plaçant un polariseur à chacune des interfaces entre la couche intermédiaire et les couches supraconductrices, un ensemble polariseur/analyseur est créé permettant de contrôler la polarisation relative des supercourants non conventionnels à travers chaque interface: Si les première et seconde magnétisations sont antiparallèles (180° entre elles), aucun des porteurs de charge, électron ou trou, généré à la première interface avec un spin parallèle à la première magnétisation, ne pourra, après circulation à travers la couche intermédiaire, traverser le second polariseur et atteindre la seconde interface. Aucun courant supraconducteur ne pourra traverser la jonction Josephson. Celle-ci sera dans un état bloqué.

En revanche, lorsque les première et seconde magnétisations sont parallèles entre elles (0°), un porteur de charge, électron ou trou, généré, à la première interface, avec un spin parallèle à la première magnétisation, pourra, après circulation à travers la couche intermédiaire, traverser le second polariseur et atteindre la seconde interface où il pourra participer à la génération d'un courant. Un courant supraconducteur pourra donc circuler à travers la jonction Josephson. Celle-ci sera dans un état passant.

Le composant 10 comporte ainsi un moyen de commande 12 propre à modifier l'orientation de la seconde magnétisation M4 le long de la direction de magnétisation pour placer le composant soit dans l'état passant, dans lequel les première et seconde magnétisations sont parallèles entre elles, soit dans un état bloquant, dans lequel les première et seconde magnétisations sont antiparallèles entre elles.

Le moyen de commande 12 est par exemple constitué d'un circuit permettant d'appliquer une impulsion de courant le long d'un fil positionné convenablement au voisinage du second polariseur 4. Pour commander l'état de magnétisation, ce courant de commande devra avoir une intensité supérieure à un seuil de commande, ce qui sera supposé dans la suite de cet exposé. Une impulsion de courant $I_{ON}$ dans un premier sens permet de placer la seconde magnétisation parallèlement à la direction de magnétisation ; une impulsion de courant $I_{OFF}$ dans un second sens, opposé au premier, permet de placer la seconde magnétisation antiparallèlement à la direction de magnétisation.

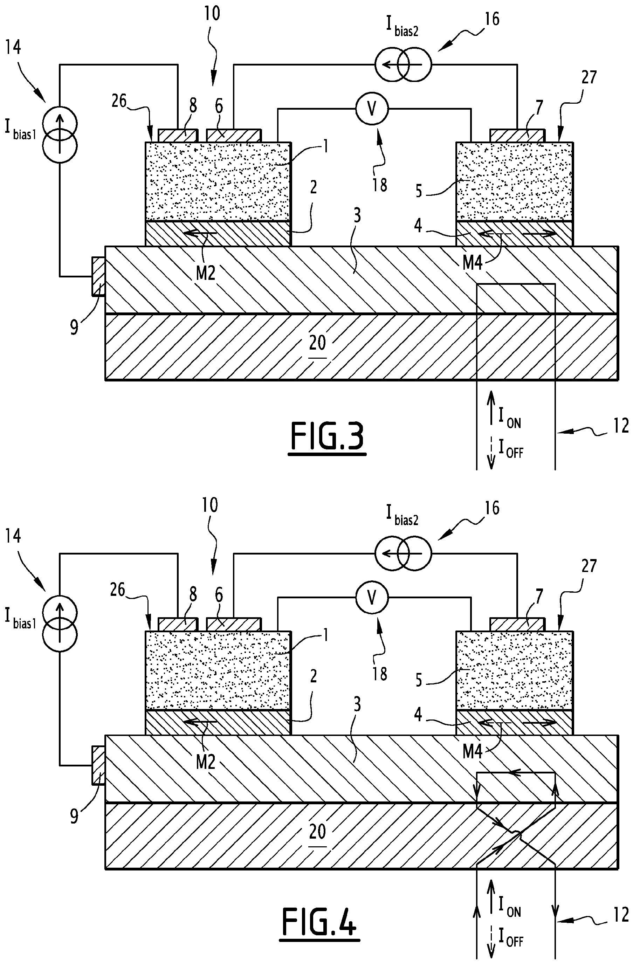

Dans les circuits logiques qui seront décrits ci-dessous, dans lesquels le composant 10 est la brique de base, nous faisons le choix que l'impulsion $I_{ON}$ équivaut à un bit d'entrée à « 0 » et l'impulsion $I_{OFF}$ a un bit d'entrée à « 1 ». Le choix inverse serait tout aussi acceptable, avec pour conséquence une redéfinition de la fonction logique des portes décrites ci-dessous. Prendre le complément du niveau logique sur un bit d'entrée revient à configurer le fil de commande de façon à ce que le courant de commande circule à proximité du polariseur dans un sens opposé, comme montré dans la figure 4.

Le composant 10 peut comporter une première source de polarisation électrique 14 propre à appliquer un premier courant $I_{bias1}$ entre une borne 8 en contact de la première couche 1 et une borne 9 en contact de la couche intermédiaire 3.

Le composant 10 peut comporter une seconde source de polarisation électrique 16 propre à appliquer un second courant $I_{bias2}$ entre une borne 6 en contact de la première couche 1 et une borne 7 en contact avec la seconde couche 5.

Le composant 10 peut comporter un dispositif de mesure de tension 18 propre à mesurer la tension entre les première et seconde couches 1 et 5.

Un second mode de réalisation va être décrit en référence à la figure 3. Les éléments du second mode de réalisation similaires ou identiques à ceux du premier mode de réalisation sont indiqués par le même chiffre de référence.

Le composant 10 comporte un substrat 20. Le matériau du substrat est par exemple du saphir, du $SrTiO_3$, etc.

Une couche intermédiaire 3 recouvre le substrat 20.

Une face supérieure libre de la couche intermédiaire 3, opposée à une face inférieure en contact avec le substrat 20, porte des première et seconde électrodes 26 et 27, respectivement.

La première électrode 26 résulte de la superposition d'un premier polariseur 2 en un matériau ferromagnétique et d'une première couche 1 en un matériau supraconducteur.

La seconde électrode 27 résulte de la superposition d'un second polariseur 4 en un matériau ferromagnétique et d'une seconde couche 5 en un matériau supraconducteur.

Les première et seconde couches 1 et 5, les premier et second polariseurs 2 et 4 et la couche intermédiaire 3 sont similaires aux couches correspondantes du premier mode de réalisation de la figure 2, en termes de matériau et d'épaisseur.

Les premier et second polariseurs 2 et 4 sont avantageusement réalisés simultanément au cours d'une étape de croissance d'un matériau ferromagnétique. Elles présentent alors généralement la même épaisseur.

Les première et seconde couches 1 et 5 sont avantageusement réalisées simultanément au cours d'une étape de croissance d'un matériau supraconducteur. Elles présentent alors généralement la même épaisseur.

Compte tenu des dimensions évoquées ci-dessus, une technologie de réalisation d'un tel composant est la lithographie par faisceau d'électrons.

Le moyen de commande 12 comporte un fil disposé à proximité du second polariseur 4 de manière à ce qu'un courant $I_{ON}$ ou $I_{OFF}$ circulant dans le fil produise un champ magnétique propre à modifier l'orientation de la magnétisation M4 du polariseur 4.

Une première source de polarisation électrique ou « biais »14 peut être connectée entre la couche intermédiaire 3 et la première couche 1 supraconductrice.

Une seconde source de polarisation électrique ou « biais »16 peut être connectée à des bornes 6 et 7 prévues sur chacune des électrodes 26 et 27, qui sont réalisées par exemple par un dépôt métallique, de préférence un dépôt d'or, sur les couches en matériau supraconducteur.

Sur la figure 4 est représentée une variante du mode de réalisation de la figure 3, qui ne diffère de ce dernier que par le fait que le fil de commande est conformé de façon à ce que le courant de commande $I_{ON}/I_{OFF}$ circule à proximité du polariseur dans un sens opposé par rapport à celui du mode de réalisation de la figure 3. La magnétisation de l'électrode par le courant $I_{ON}$ est renversée, ce qui revient à prendre le complément du signal logique correspondant au courant $I_{ON}$ appliqué en entrée du composant de la figure 3. Ainsi, alors que le composant de la figure 3 est un opérateur « EQV » d'équivalence logique (« 1 » en entrée E donne « 1 » en sortie S et « 0 » en entrée E donne « 0 » en sortie S, ou encore S=E), le composant de la figure 4 réalise la fonction de l'opération logique « NON » (« 1 » en entrée donne « 0 » en sortie et « 0 » en entrée donne « 1 » en sortie, ou encore S= $\bar{E}$).

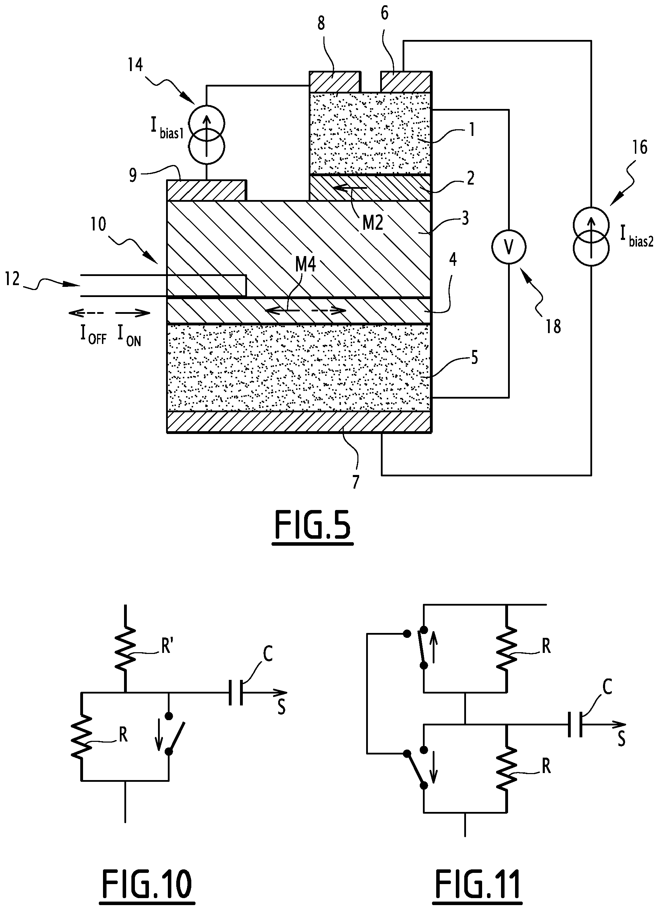

Sur la figure 5 encore un autre mode de réalisation du composant 10 est représenté. Ce mode de réalisation est similaire à celui de la figure 1, à l'exception du fait que les couches 1 et 2 ont une extension transversale réduite par rapport à la couche 3. De cette manière, la couche 2 ne recouvre pas la totalité d'une surface de contact de la couche 3, qui peut alors recevoir la borne 9 d'injection du premier courant $I_{bias1}$, lorsque celui-ci existe.

Il est à noter que le sens des premier et second courants de biais indiqué sur les figures est arbitraire et peut être réglé comme il convient, en fonction de l'application que trouve le composant.

En variante, c'est la magnétisation M2 de la couche 2 qui est commandée au cours de l'utilisation du composant 10 et non la magnétisation M4.

Dans l'un des modes fonctionnement possibles de ce composant, dans lequel le composant 10 n'est associé qu'à une seconde source de polarisation électrique 16, la source 16 est propre à appliquer un courant $I_{bias2}$ entre des bornes 6 et 7 du composant 10, de manière à permettre, lorsque le composant est dans l'état passant (c'est-à-dire lorsque la dernière impulsion de courant reçue sur l'entrée de commande du composant était égale à $I_{ON}$) et que $I_{bias2}$ est en-deçà du courant critique $I_c$, la circulation d'un courant supraconducteur. La tension V mesurée avec le dispositif de mesure de tension 18 est donc nulle. En revanche, lorsque le composant est dans l'état bloqué ($I_{OFF}$), le courant circulant à travers le composant est non supraconducteur, et la tension mesurée avec le dispositif de mesure de tension 18 est non nulle

Dans un autre mode de fonctionnement, dans lequel le composant 10 est associé à des première et seconde sources de polarisation électrique 14 et 16, les courants $I_{bias1}$ et $I_{bias2}$ sont appliqués simultanément. Si la somme des courants $I_{bias1}$ et $I_{bias2}$ est telle que l'on se situe dans la partie de la caractéristique courant-tension de la jonction Josephson en-deçà du courant critique $I_c$, lorsque l'on bascule le composant dans l'état passant ($I_{ON}$), un courant supraconducteur circule à travers le composant. En revanche, lorsque le composant est dans l'état bloqué ($I_{OFF}$), le courant circulant à travers le composant est non supraconducteur, et la tension mesurée avec le dispositif de mesure de tension 18 est non nulle.

Ainsi, on obtient un composant spintronique à jonction Josephson pouvant être commandé autrement que par une variation de la tension appliquée entre ses bornes. Ce composant constitue une vanne de spin à supercourant polarisé en spin.

La commande du changement d'état d'un tel interrupteur est une impulsion de champ magnétique, qui peut être causée par la circulation d'une impulsion de courant de commande (dans ou au voisinage de la couche ferromagnétique).

Dans un mode de réalisation dans lequel l'état de chacune des deux couches ferromagnétiques 2 et 4 est commandable, alors le composant se comporte comme une porte « comparaison » ou son complément « XOR », selon que les connections des fils de commande en entrée du composant font passer le courant dans le même sens, ou en sens opposé (en utilisant une disposition de l'un des deux fils de commande analogue au schéma de la figure 4). Dans ce dernier cas, si l'une des deux entrées est maintenue au zéro logique, le composant se comporte comme un inverseur, ou porte « NON ».

Incidemment, puisque le composant est sensible aux variations du champ magnétique, une impulsion magnétique modifiant la magnétisation d'un des polariseurs de manière à basculer le composant de l'état bloquant vers l'état passant ou inversement, une utilisation de ce composant en tant que capteur de variations du champ magnétique est envisageable.

Bien que le principe du présent composant puisse être mis en oeuvre au moyen de matériau supraconducteur à basse température, l'utilisation de matériaux supraconducteurs à haute température est préférable, en particulier pour permettre l'intégration du composant électronique dans des circuits mis en oeuvre dans des systèmes micro-cryogéniques portables.

Plusieurs modes de réalisation de circuits logiques intégrant au moins un composant spintronique, le ou chaque composant étant conforme au composant décrit ci-dessus, vont maintenant être présentés.

Un élément identique ou similaire à un élément d'un mode de réalisation précédent est référencé par un nombre correspondant au nombre utilisé pour référencer cet élément identique ou similaire augmenté d'une centaine.

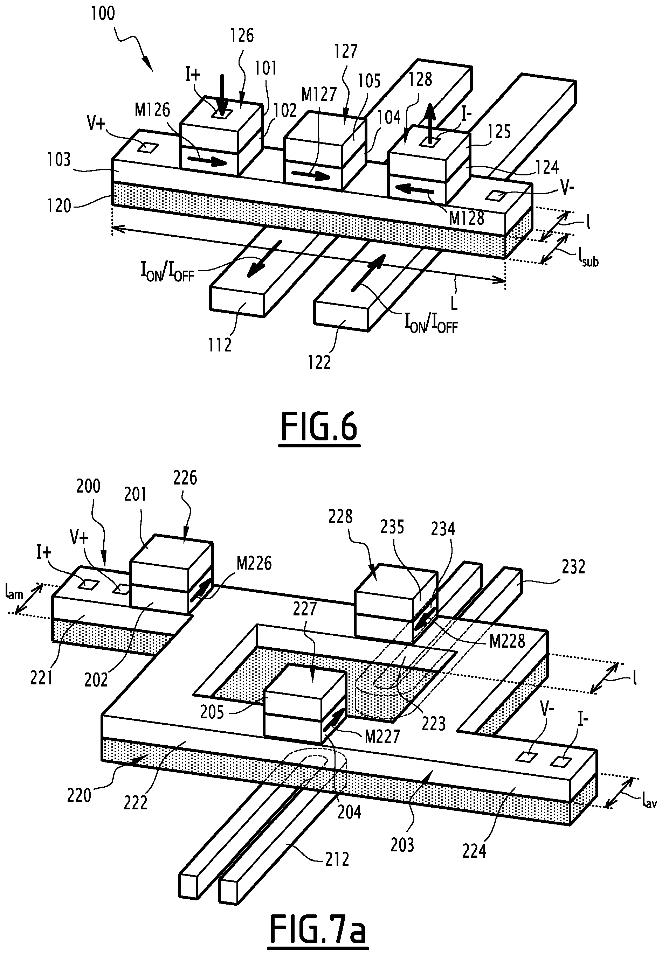

Dans un premier mode de réalisation d'un circuit logique, représenté à la figure 6, le circuit logique 100 est une porte « OU », c'est-à-dire réalisant l'opérateur logique « OU ».

Le circuit 100 comporte un substrat isolant 120, par préférence, conformé de manière à constituer une bande selon une direction principale D. Le substrat présente une longueur L et une largeur $l_{sub}$.

Le circuit 100 comporte une couche intermédiaire 103 en un métal normal recouvrant le substrat 120, conformée de manière à constituer une bande de largeur l.

Une face supérieure libre de la couche intermédiaire 103, opposée à une face inférieure en contact avec le substrat 120, porte des première, seconde et troisième électrodes, respectivement 126, 127 et 128.

Les électrodes sont espacées les unes des autres longitudinalement.

Chaque électrode s'étend latéralement sur la quasi-totalité de la largeur l de la bande constituée par la couche intermédiaire 103.

La première électrode 126 résulte de la superposition d'un premier polariseur 102 en un matériau ferromagnétique et d'une première couche 101 en un matériau supraconducteur.

La seconde électrode 127 résulte de la superposition d'un second polariseur 104 en un matériau ferromagnétique et d'une seconde couche 105 en un matériau supraconducteur.

La troisième électrode 128 résulte de la superposition d'un troisième polariseur 124 en un matériau ferromagnétique et d'une troisième couche 125 en un matériau supraconducteur.

La polarisation M126 de la première électrode est fixe et constitue une référence.

Le circuit logique 100 comporte un moyen de commande 112 de la polarisation magnétique M127 du second polariseur 104 et un moyen de commande 122 de la polarisation magnétique M128 du troisième polariseur 124.

Chaque moyen de commande comporte un fil disposé à proximité du polariseur correspondant de manière à ce qu'un courant $I_{ON}$ ou $I_{OFF}$, de sens opposé à $I_{ON}$, circulant dans le fil produise un champ magnétique propre à modifier l'orientation de la magnétisation du polariseur correspondant.

De manière générale, dans les circuits logiques décrits dans le présent document, l'impulsion $I_{ON}$ équivaut à un bit d'entrée « 0 », et l'impulsion $I_{OFF}$ à un bit d'entrée « 1 ». Prendre le complément du niveau logique sur un bit d'entrée revient à configurer le fil de façon à ce que le courant de commande circule à proximité du polariseur dans un sens opposé, comme montré dans la figure 4. Dans d'autres modes de réalisation, des courants de commande polarisés en spin peuvent être injectés directement dans les polariseurs pour renverser la magnétisation par effet de spin-torque.

Le circuit 100 comporte une borne de mesure à chacune des extrémités longitudinales de la bande. Le circuit 100 comporte ainsi une borne de mesure V+ et une borne de mesure V-. Le signal de sortie mesuré entre les bornes de mesure est une tension de mesure.

Le circuit 100 comporte des bornes de biais d'application d'un signal de biais. Une première borne de biais I+ est située sur la première couche 101 de la première électrode et une seconde borne de biais I- est située sur la troisième couche 125 de la troisième électrode. Le signal de biais appliqué entre les bornes de biais est un courant de biais.

Entre les première et seconde électrodes d'une part et les première et troisième électrodes d'autre part se trouvent deux vannes de spin du type à supercourant polarisé en spin, chaque vanne de spin étant conforme à ce qui a été présenté ci-dessus, en termes de matériau, épaisseurs des couches, etc. En particulier, la distance entre les électrodes et l'épaisseur des polariseurs des électrodes dépend de la longueur de cohérence $L_N$ des porteurs de charge dans la couche intermédiaire et de la longueur de cohérence $L_P$ des porteurs de charge dans les polariseurs.

Au cours de l'utilisation du circuit 100, la polarisation M126 de la première électrode 126 est fixe, tandis que les polarisations M127 et M 128 des seconde et troisième électrodes sont modifiables indépendamment l'une de l'autre. Les seconde et troisième électrodes sont dites « libres », tandis que la première électrode est dite de référence.

En dessous d'un seuil de courant $I_C$, un supercourant peut s'écouler entre la première borne de biais I+ et la seconde borne de biais I-, à travers la première électrode 126, la couche intermédiaire 103 (en passant sous la seconde électrode 127), et la troisième électrode 128 uniquement si les polarisations M127 et M128 des seconde et troisième électrodes sont parallèles à la polarisation M126 de la première électrode. Dans ce cas, une tension nulle est mesurée entre les bornes de mesure V+ et V-.

Il suffit en revanche que l'une des électrodes libres présente une polarisation antiparallèle par rapport à la magnétisation M126 de la première électrode, pour qu'une tension non nulle soit mesurée entre les bornes de mesure V+ et V-.

D'un point de vue logique, le niveau de la tension de mesure entre les bornes V+ et V- correspond à un opérateur «OU» sur les impulsions de courant $I_{ON}$ / $I_{OFF}$ qui établissent les polarisations des polarisateurs des électrodes libres, comme le montre le tableau suivant, dans lequel le bit d'entrée prend la valeur « 0 » pour une impulsion de courant $I_{ON}$ (qui établit une aimantation d'une électrode libre parallèle à celle de l'électrode de référence) et la valeur « 1 », pour une impulsion de courant $I_{OFF}$ (qui établit une aimantation d'une électrode libre antiparallèle à celle de l'électrode de référence). Une tension mesurée non-nulle équivaut à un bit de sortie « 1 », tandis qu'une tension mesurée proche de zéro volts équivaut à un bit de sortie « 0 ».

| Impulsion de courant à travers le fil qui commande la polarisation de la seconde électrode par rapport à la première électrode | Impulsion de courant à travers le fil qui commande la polarisation de la troisième électrode par rapport à la première électrode | Niveau de la tension mesurée entre les bornes V+ et V- |
|---|---|---|
| 1 | 1 | 1 |
| 0 | 1 | 1 |
| 1 | 0 | 1 |
| 0 | 0 | 0 |

Dans des variantes de réalisation du circuit 100, la fonction de polariseur fixe est assurée par la seconde électrode, respectivement la troisième électrode, ce qui génère également une fonction « OU » entre les première et troisième électrodes, respectivement la première et la seconde électrodes.

Si la magnétisation du polariseur d'aucune des trois électrodes n'est fixe, on obtient un circuit logique se comportant comme une porte à trois entrées A (correspondant à la magnétisation du premier polariseur), B (correspondant à la magnétisation du second polariseur) et C (correspondant à la magnétisation du troisième polariseur) et une sortie S (correspondant au signal de mesure), qui correspond alors au test logique complémentaire de « A==B==C ? », ce qui correspond à la fonction logique « A ≠B ou B≠C ou C≠A » généralisée à trois entrées, dont le tableau de vérité est le suivant :

| C | B | A | S |
|---|---|---|---|
| 0 | 0 | 0 | 0 |
| 0 | 1 | 0 | 1 |
| 0 | 1 | 1 | 1 |
| 0 | 0 | 1 | 1 |
| 1 | 0 | 0 | 1 |
| 1 | 0 | 1 | 1 |
| 1 | 1 | 0 | 1 |
| 1 | 1 | 1 | 0 |

Sur la figure 7a est représenté schématiquement un second mode de réalisation d'un circuit logique dans lequel le circuit logique 200 est une porte « ET », c'est-à-dire réalisant l'opération logique « ET ».

Le circuit 200 comporte ainsi un substrat 220.

Le circuit 200 comporte une couche intermédiaire 203 déposée sur le substrat 220 et conformée selon un motif comportant une portion amont 221, une portion intermédiaire et une portion aval 224.

Les portions amont et aval sont en forme de bande de largeurs $l_{am}$ et $l_{av}$.

La portion intermédiaire comporte une boucle définissant une branche supérieure 223 et une branche inférieure 222.

Les branches inférieure 222 et supérieure 223 forment des bandes de largeur l.

Une face supérieure de la couche intermédiaire 203 porte des première, seconde et troisième électrodes, respectivement 226, 227 et 228.

La première électrode 226 est placée sur la portion amont 221 du motif du substrat 220.

La seconde électrode 227 est placée sur la branche inférieure 222 de la portion intermédiaire du motif.

La troisième électrode 228 est placée sur la bande supérieure 223 de la portion intermédiaire du motif.

Chaque électrode s'étend latéralement sur la quasi-totalité de la largeur l de la couche intermédiaire 203.

La première électrode 226 résulte de la superposition d'un premier polariseur 202 en un matériau ferromagnétique et d'une première couche 201 en un matériau supraconducteur.

La seconde électrode 227 résulte de la superposition d'un second polariseur 204 en un matériau ferromagnétique et d'une seconde couche 205 en un matériau supraconducteur.

La troisième électrode 228 résulte de la superposition d'un troisième polariseur 234 en un matériau ferromagnétique et d'une troisième couche 235 en un matériau supraconducteur.

Le circuit 200 comporte un moyen de commande 212 de la polarisation magnétique du second polariseur 204 et un moyen de commande 232 de la polarisation magnétique du troisième polariseur 234.

Chaque moyen de commande comporte par exemple un fil disposé à proximité du polariseur correspondant de manière à ce qu'un courant $I_{ON}$ ou $I_{OFF}$ circulant dans le fil produise un champ magnétique propre à modifier l'orientation de la magnétisation du polariseur correspondant. Dans d'autres modes de réalisation, des courants de commande polarisés en spin sont injectés directement dans les polariseurs pour renverser la magnétisation par effet de spin-torque.

Le circuit 200 comporte une paire de bornes de mesure, respectivement V+ et V-, situées à chacune des extrémités du motif. La première borne de mesure V+ est ainsi située sur la portion amont 221 en amont de la première électrode, et la seconde borne de mesure V- est située sur la portion aval 224 en aval des seconde et troisième électrodes. Dans le mode de réalisation de la figure 7a, le signal de sortie est une tension de mesure.

Le circuit 200 comporte des bornes de biais d'application d'un signal de biais, qui, dans le mode de réalisation de la figure 7a est un courant de biais. Les bornes de biais sont situées à chacune des extrémités du motif de la couche 203. Le circuit 200 comporte ainsi une première borne de biais I+ en amont de la première électrode 226 et une seconde borne de biais I- en aval des seconde et troisième électrodes 227 et 228.

Les première et seconde électrodes 226 et 227, d'une part, et les première et troisième électrodes 226 et 228, d'autre part, constituent deux vannes de spin du type à supercourant polarisé en spin, chaque vanne de spin étant conforme à ce qui a été présenté ci-dessus, en termes de matériau, épaisseurs des couches, etc.

Au cours de l'utilisation du circuit 200, la polarisation M226 de la première électrode est fixe, tandis que les polarisations M227 et M228 des seconde et troisième électrodes sont modifiables, indépendamment l'une de l'autre.

Un supercourant peut s'écouler entre la première borne de biais I+ et la seconde borne de biais I-, à travers la première électrode 226, la couche intermédiaire 203 en passant sous la seconde électrode 227 ou sous la troisième électrode 228), si la polarisation M227 de la seconde électrode est parallèle à la polarisation M226 de la première électrode, ou si la polarisation M228 de la troisième électrode est parallèle à la polarisation M226 de la première électrode. Dans ce cas, une tension nulle est mesurée entre les bornes de mesure V+ et V-.

En revanche si les deux électrodes libres présentent une polarisation antiparallèle à la magnétisation M226 de la première électrode, une tension non-nulle est mesurée entre les bornes de mesure V+ et V-.

D'un point de vue logique, le niveau de la tension de mesure entre les bornes V+ et V- correspond à un opérateur « ET » sur les polarisations des polarisateurs des électrodes libres, comme le montre le tableau suivant, dans lequel le bit d'entrée prend la valeur « 0 » pour une impulsion de courant $I_{ON}$ (qui établit une magnétisation d'une électrode libre parallèle à celle de l'électrode de référence) et la valeur « 1 », pour une impulsion de courant $I_{OFF}$ (qui établit une magnétisation d'une électrode libre antiparallèle à celle de l'électrode de référence). Une tension mesurée non-nulle équivaut à un bit de sortie « 1 », tandis qu'une tension mesurée proche de zéro volts équivaut à un bit de sortie « 0 ».

| Entrée A : Impulsion de courant à travers le fil qui commande la polarisation de la seconde électrode par rapport à la première électrode | Entrée B : Impulsion de courant à travers le fil qui commande la polarisation de la troisième électrode par rapport à la première électrode | Sortie S : Niveau de la tension entre les bornes V+ et V- |
|---|---|---|
| 1 | 1 | 1 |
| 0 | 1 | 0 |
| 1 | 0 | 0 |
| 0 | 0 | 0 |

Dans une variante de réalisation du circuit 200, la deuxième, respectivement la troisième électrode, est choisie comme polariseur de spin en rendant sa magnétisation fixe. La fonction logique obtenue alors n'est plus la fonction « ET », mais le complémentaire d'une implication correspondant à « $\overline{C \Rightarrow A}$ » lorsque B est fixé égal à « 1 » et dont le tableau de vérité est le suivant :

| C | A | S |
|---|---|---|
| 0 | 0 | 0 |
| 0 | 1 | 1 |
| 1 | 0 | 0 |
| 1 | 1 | 0 |

Et correspondant à « non (A=>C) » lorsque B est fixé égal à « 0 » et dont le tableau de vérité est le suivant :

| C | A | S |
|---|---|---|
| 0 | 0 | 0 |
| 0 | 1 | 0 |
| 1 | 0 | 1 |
| 1 | 1 | 0 |

Si la magnétisation du polariseur d'aucune des électrodes n'est maintenue fixe, on crée une troisième entrée sur le circuit, qui correspond alors au test logique « A==C ET B==C ? » dont le tableau de vérité est le suivant :

| C | B | A | S |
|---|---|---|---|
| 1 | 1 | 1 | 1 |
| 1 | 0 | 1 | 0 |
| 1 | 1 | 0 | 0 |
| 1 | 0 | 0 | 0 |

(suite)

| C | B | A | S |
|---|---|---|---|
| 0 | 1 | 1 | 0 |
| 0 | 0 | 1 | 0 |
| 0 | 1 | 0 | 0 |
| 0 | 0 | 0 | 1 |

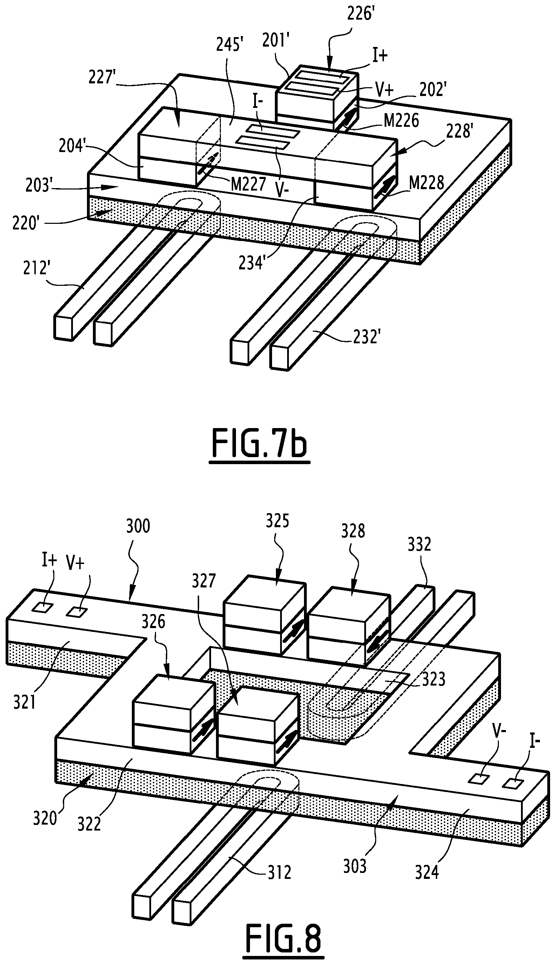

Dans une variante de réalisation du circuit logique « ET », représentée à la figure 7b, la couche intermédiaire 203' est déposée sur un substrat 220' ; la première électrode 226' est simple et résulte de la superposition d'un premier polariseur 202', en un matériau ferromagnétique, et d'une première couche 201', en un matériau supraconducteur, le premier polariseur 202' étant en contact avec la couche intermédiaire 203' ; la deuxième électrode est double parce que constituée d'une deuxième électrode simple 227', qui résulte de la superposition d'un second polariseur 204', en un matériau ferromagnétique, et d'une couche 245', en un matériau supraconducteur, le second polariseur 204' étant en contact avec la couche intermédiaire 203', et d'une troisième électrode simple 228' qui résulte de la superposition d'un troisième polariseur 234', en un matériau ferromagnétique, et de la couche 245', le troisième polariseur 234' étant en contact avec la couche intermédiaire 203'. Des moyens de commande 212' et 232' sont disposés respectivement à proximité des polariseurs 204' et 234'. Des contacts sont déposés sur les couches supraconductrices 201' et 245'.

Ainsi, la couche 245' est commune aux seconde et troisième électrodes simples 227' et 228'. Elle s'étend au-dessus des polariseurs 204' et 234'.

L'avantage de cette variante de réalisation est de constituer une structure présentant une forte compacité.

Une porte « ET » à multiples entrées est facilement réalisable en augmentant le nombre de plots polariseur, en matériau ferromagnétique, entre la couche intermédiaire et la couche commune en matériau supraconducteur, chaque plot étant associé à un moyen de commande permettant de contrôler sa magnétisation. Les contacts seront de préférence sur la couche supraconductrice de la première électrode et sur la couche commune supraconductrice.

Dans une autre variante, la portion intermédiaire du circuit logique est constituée par la mise en parallèle électrique de plusieurs bandes définissant chacune des branches, chaque branche étant identifiée par un entier k, étant connectée d'une part à la portion amont et d'autre part à la portion aval, et portant une électrode, dont l'aimantation correspond à un niveau logique $V_k$.

L'aimantation de la première électrode, placée sur la portion amont de préférence en aval de la borne de mesure, correspondant à un niveau logique C, le niveau du signal de sortie pris entre les bornes de mesure situées aux extrémités du motif du circuit correspond à une fonction logique NOR($V_k$==C) dont la sortie S est égale à « 1 », si tous les $V_k$ sont différents de C, dont le tableau de vérité est le suivant (dans lequel « x » représente indifféremment les valeurs « 0 » et « 1 »):

| C | $V_i$ | $V_{k \neq i}$ | S |
|---|---|---|---|
| 0 | 1 | 1 | 1 |
| 0 | 0 | x | 0 |
| 1 | 0 | 0 | 1 |
| 1 | 1 | x | 0 |

A la figure 8 est représentée une variante de réalisation du circuit logique de la figure 7. Selon cette variante, le circuit 300 comporte deux premières électrodes.

Une première électrode supérieure 325 est disposée sur la branche supérieure 323 du motif, en amont de la troisième électrode 328.

Une première électrode inférieure 326 est disposée sur la branche inférieure 322 du motif, en amont de la seconde électrode 327.

Lorsque les polarisations des premières électrodes supérieure et inférieure sont égales en orientation, on retrouve le fonctionnement décrit du circuit 200. Et lorsque la polarisation d'une de ces deux électrodes est inversée, ceci revient à inverser la commande de l'entrée correspondante, réalisant de façon électrique la même fonction d'inversion qui a été décrite pour le mode de réalisation de la figure 4.

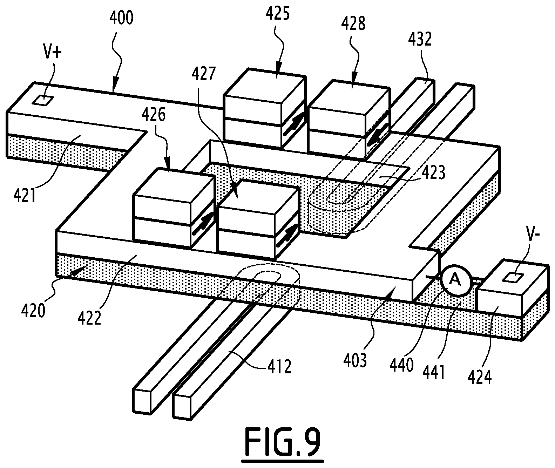

A la figure 9, est représentée une variante de réalisation du circuit de la figure 8. Selon cette variante, le circuit 400 est polarisé en tension de biais et le signal de sortie correspond au courant traversant une résistance 440.

Le circuit 400 comporte ainsi des bornes de biais V+ et V- à chacune des extrémités du motif du substrat 420. Les bornes de mesure du signal de sortie ne sont pas représentées sur la figure 9.

Dans le circuit 400, la couche intermédiaire 403 est interrompue dans la portion aval 424 du motif. Elle présente une découpe 441. Une résistance 440 est connectée de part et d'autre de la découpe 441. La résistance 440 provoque l'apparition d'une tension lors du passage d'un courant. Très schématiquement, si l'on polarise en tension le circuit logique 400, cette tension se retrouve aux bornes de la résistance 440 si le circuit est dans l'état « 0 » (état supraconducteur), ou répartie aux bornes des électrodes et de la résistance 440 en proportion des valeurs relatives de la résistance 440 et de la résistance de la couche 420 dans l'état « 1 » (état normal non supraconducteur).

Il est à noter que le courant circulant dans les fils de commande est propre à générer un champ magnétique capable de renverser l'aimantation du polariseur situé dans son voisinage. Pour les électrodes de LCMO, le champ coercitif doit être de l'ordre de quelques dixièmes de Gauss. En tenant compte de l'épaisseur totale du substrat et de la couche intermédiaire, un courant de commande de l'ordre de 0,1 mA est suffisant pour générer un champ magnétique de l'ordre de 20 Gauss.

Si l'on choisit d'utiliser des courants de commande plus faibles, ou si les champs magnétiques à générer sont plus élevés, à la place de fils conducteur, de petites bobines peuvent être utilisées en tant que moyen de commande, à condition de faire circuler un courant à travers le polariseur. Alternativement, pour manipuler la direction de polarisation via des effets de spin-torque, on peut envisager d'injecter des impulsions de courant à travers le polariseur pour polariser en spin directement celui-ci.

La modification de l'état de magnétisation d'une électrode libre ne nécessite qu'une courte impulsion.

Etant donné que le circuit logique fonctionne au-dessous de la transition supraconductrice, ces fils ou bobines des moyens de commande pourraient être réalisés en YBCO. Ceci présente l'avantage d'une dissipation de puissance quasiment nulle dans le circuit de commande.

Les circuits logiques présentés ci-dessus peuvent être placés en cascade pour obtenir des circuits logiques réalisant des fonctions complexes, et ceci à l'image de ce qui est connu par l'homme du métier dans les circuits logiques à semi-conducteurs.

Les circuits logiques présentés ci-dessus se comportent comme une résistance équivalente R en parallèle avec un interrupteur parfait. Par conséquent, il est aisé d'adapter la résistance équivalente du circuit logique en fonction de l'électronique environnante.

La sortie d'un circuit logique à vannes de spin à supercourant polarisé en spin peut être comparée à la configuration « collecteur ouvert », qui est utilisée avec des circuits logiques à semi-conducteurs : dans ce cas l'étage de sortie du circuit logique est équivalent à un interrupteur dont l'une des bornes est connectée à la masse et le signal de sortie est stable.

Cependant, le circuit logique à vannes de spin à supercourant polarisé en spin ne nécessite pas que les signaux d'entrée appliqués aux électrodes polarisantes soient stables : le signal d'entrée peut être stable ou pulsé. Dans les deux cas, le courant de commande doit pouvoir changer de signe pour changer la polarité de la magnétisation du polariseur de chaque électrode polarisante. Dans le cas où l'on n'utilise que des impulsions pour commander les entrées du circuit logique, un circuit différentiateur RC peut être utilisé, comme celui représenté sur la figure 10.

Sur ces figures, la flèche verticale symbolise le signal de basculement de la polarisation d'une électrode et la flèche vers la droite représente la sortie S du circuit logique. Celle-ci peut être branchée à l'entrée d'un autre circuit logique, en cascade.

Dans une version préférable représentée à la figure 11, le condensateur C est associé avec des sorties complémentaires de circuits logiques montés en miroir pour éviter la limitation de la vitesse par la constante de temps RC, pour alimenter l'entrée de la ligne (fil ou bobine) générant le champ magnétique de commande du circuit logique en cascade.

En variante, alors que dans les modes de réalisation des figures 6 à 9 les polariseurs sont disposés sur la couche intermédiaire, les couches supraconductrices étant disposées sur les polariseurs, d'autres structures d'empilement sont envisageables, comme par exemple l'empilement inverse dans lequel les couches supraconductrices sont disposées sur le substrat, les polariseurs disposés sur les couches supraconductrices, et la couche intermédiaire de la jonction disposée sur les polariseurs.

Les avantages du présent circuit logique sont les suivants:

- Réduction de la dissipation par effet Joule, car l'information de spin est portée par un supercourant.
- un très grand rapport ON/OFF, étant donné que le changement de résistance est compris entre zéro et une valeur finie.
- La sortie du circuit logique peut être soit une tension, soit un courant, assurant une versatilité d'intégration dans des circuits complexes.

**Revendications**

1. Circuit logique (100 ; 200 ; 300 ; 400), **caractérisé en ce qu'**il comporte :

- une couche intermédiaire (103; 203; 303; 403), constituée d'un matériau conducteur du courant électrique et conformée selon un motif ;
- une première électrode et une pluralité d'électrodes, qui comporte au moins des seconde et troisième électrodes (126, 127, 128 ; 226, 227, 228 ; 325, 326, 327, 328 ; 425, 426, 427, 428) ;

chaque électrode comportant :

◦ Un polariseur, en un matériau ferromagnétique, placé en un point particulier du motif de la couche intermédiaire, et présentant une magnétisation,
◦ Une couche supraconductrice, en un matériau supraconducteur, disposée sur une surface du polariseur opposée à une surface du polariseur en contact avec la couche intermédiaire ;
- au moins un moyen de commande (112 ; 212 ; 312 ; 412) propre à modifier la magnétisation du polariseur d'une électrode parmi les seconde et troisième électrodes ;
- au moins un autre moyen de commande (122 ; 232 ; 332 ; 432) propre à modifier la magnétisation du polariseur de l'autre électrode parmi les seconde et troisième électrodes ;

les première et seconde électrodes, d'une part, et les première et troisième électrodes, d'autre part, constituant deux vannes de spin du type à supercourant polarisé en spin,

- des bornes de biais d'application d'un signal de biais; et,
- des bornes de mesure d'un signal de sortie,

un niveau du signal de sortie étant corrélé à une orientation des première, seconde et troisième magnétisations entre elles.

2. Circuit logique (100) selon la revendication 1, dans lequel, le motif étant une bande, les première, seconde et troisième électrodes sont disposées successivement selon la longueur de ladite bande, en ménageant un espace entre elles, et les bornes de mesure sont disposées aux extrémités de la bande, de part et d'autre des électrodes, le niveau du signal de sortie correspondant alors à un « OU » logique entre les magnétisations des seconde et troisième électrodes, la première magnétisation étant fixe, ou le complémentaire d'une « EQV » logique entre les magnétisations des première, seconde et troisième électrodes.

3. Circuit logique (100) selon la revendication 2, dans lequel les première et troisième électrodes portent chacune une borne de biais pour l'application du signal de biais, qui est un courant, et le signal de sortie est une tension mesurée entre les bornes de mesure.

4. Circuit logique (200) selon la revendication 1, dans lequel le motif comporte :

- des portions amont (221) et aval (224) constituées chacune par une bande qui est en contact électrique avec l'une des bornes de mesure ; et,
- une portion intermédiaire constituée par une bande en forme de boucle définissant une branche supérieure (223) et une branche inférieure (222),

la première électrode étant placée sur la portion amont, la seconde électrode, sur la branche inférieure et la troisième électrode, sur la branche supérieure, un niveau du signal de sortie pris entre les bornes de mesure situées aux extrémités du motif correspond à un « ET » logique entre les magnétisations des seconde et troisième électrodes.

5. Circuit logique (200) selon la revendication 1, dans lequel le motif comporte :

- des portions amont (221) et aval (224) constituées chacune par une bande qui est en contact électrique avec l'une des bornes de mesure, une première électrode étant placée sur la portion amont en aval de la borne de mesure, une aimantation de la première électrode correspondant à un niveau logique C ; et,
- une portion intermédiaire constituée par la mise en parallèle électrique de plusieurs bandes définissant chacune des branches, chaque branche étant identifiée par un entier k, étant connectée d'une part à la portion amont et d'autre part à la portion aval et portant une électrode, dont une aimantation correspondant à un niveau logique $V_k$,

un niveau du signal de sortie pris entre les bornes de mesure situées aux extrémités du motif correspond à une

fonction logique NOR($V_k$==C) entre les magnétisations des électrodes.

6. Circuit logique (200) selon l'une des revendications 4 ou 5, dans lequel le signal de sortie est une tension mesurée entre les bornes de mesure (V+, V-), et un courant de polarisation est appliqué entre les bornes de biais (I+, I-), dont une première borne de biais fait partie de la portion amont, en amont de la première électrode, et dont une seconde borne de biais fait partie de la portion aval du circuit, en aval des électrodes.

7. Circuit logique (100 ; 200 ; 300 ; 400) selon l'une quelconque des revendications 1 à 5, dans lequel, la couche intermédiaire étant interrompue par une découpe, le signal de sortie est un courant traversant une résistance connectant la couche intermédiaire de part et d'autre de la découpe, et la source de polarisation étant une tension de biais appliquée entre les bornes de biais situées à chacune des extrémité du motif.

8. Circuit logique (100 ; 200 ; 300 ; 400) selon l'une quelconque des revendications 1 à 7, dans lequel le matériau supraconducteur des couches supraconductrices de chaque électrode est un matériau supraconducteur à haute température critique, de préférence du YBCO.

9. Circuit logique (100 ; 200 ; 300 ; 400) selon la revendication 8, dans lequel une épaisseur des couches supraconductrices de chaque électrode est choisie entre 20 et 40 nm, de préférence 25 et 35 nm, de préférence encore égale à 30 nm.

10. Circuit logique (100 ; 200 ; 300 ; 400) selon l'une quelconque des revendications 1 à 9, dans lequel le matériau ferromagnétique des polariseurs (2, 4) de chaque électrode est du LCMO.

11. Circuit logique (100 ; 200 ; 300 ; 400) selon la revendication 10, dans lequel une épaisseur des polariseurs de chaque électrode est choisie entre 3 et 10 nm, de préférence égale à 5 nm.

12. Circuit logique (100 ; 200 ; 300 ; 400) selon l'une quelconque des revendications 1 à 11, dans lequel le matériau de la couche intermédiaire est un métal normal, choisi parmi les oxydes de métal normal ou les métaux normaux élémentaires.

13. Circuit logique (100 ; 200 ; 300 ; 400) selon la revendication 12, dans lequel une épaisseur de la couche intermédiaire est choisie entre 15 et 25 nm, de préférence égale à 20 nm.

14. Circuit logique (100 ; 200 ; 300 ; 400) selon l'une quelconque des revendications 1 à 13, dans lequel le substrat est réalisé en un matériau choisi parmi le saphir et le $SrTiO_3$.

15. Circuit logique selon l'une quelconque des revendications 1 à 14, dans lequel une distance entre les électrodes et une épaisseur des polariseurs des électrodes dépend d'une longueur de cohérence ($L_N$) des porteurs de charge dans la couche intermédiaire et d'une longueur de cohérence ($L_P$) des porteurs de charge dans les polariseurs.

16. Circuit, **caractérisé en ce qu'**il comporte une pluralité de circuits logiques, chaque porte logique étant conforme à une porte selon l'une quelconque des revendications 1 à 15.

**Patentansprüche**

1. Logikschaltkreis (100; 200; 300; 400), **dadurch gekennzeichnet, dass** er aufweist:

   - eine Zwischenschicht (103; 203; 303; 403), die aus einem elektrischen Strom leitenden Material gebildet ist und gemäß einem Muster angepasst ist,
   - eine erste Elektrode und eine Mehrzahl von Elektroden, die mindestens eine zweite und eine dritte Elektrode (126, 127, 128; 226, 227, 228; 325, 326, 327, 328; 425, 426, 427, 428) aufweist,

   wobei jede Elektrode aufweist:

   ∘ einen Polarisator aus einem ferromagnetischen Material, der an einem bestimmten Punkt des Musters der Zwischenschicht angeordnet ist und eine Magnetisierung aufweist,
   ∘ eine Supraleiterschicht aus einem supraleitenden Material, die auf einer Oberfläche des Polarisators entgegengesetzt zu einer Oberfläche des Polarisators angeordnet ist, die mit der Zwischenschicht in Kontakt ist,
- mindestens ein Steuermittel (112; 212; 312; 412), das in der Lage ist, die Magnetisierung des Polarisators einer Elektrode von der zweiten und der dritten Elektrode zu ändern,
- mindestens ein anderes Steuermittel (122; 232; 332; 432), das in der Lage ist, die Magnetisierung des Polarisators der anderen Elektrode von der zweiten und der dritten Elektrode zu ändern,

wobei die erste und die zweite Elektrode einerseits und die erste und die dritte Elektrode andererseits zwei Spinventile des Typs mit spinpolarisiertem Suprastrom bilden,

- Bias-Anschlüsse zum Anlegen eines Bias-Signals und
- Anschlüsse zum Messen eines Ausgangssignals,

wobei ein Pegel des Ausgangssignals mit einer Ausrichtung der ersten, der zweiten und der dritten Magnetisierung untereinander korreliert.

2. Logikschaltkreis (100) gemäß Anspruch 1, wobei, wenn das Muster ein Band ist, die erste, die zweite und die dritte Elektrode nacheinander entlang der Länge des Bandes angeordnet sind, wobei ein Abstand zwischen ihnen vorgesehen ist, und die Messanschlüsse an den Enden des Bandes auf beiden Seiten der Elektroden angeordnet sind, wobei der Pegel des Ausgangssignals dann einem logischen "ODER" zwischen den Magnetisierungen der zweiten und der dritten Elektrode, wobei die erste Magnetisierung fest ist, oder dem Komplement einer "EQV"-Logik zwischen den Magnetisierungen der ersten, der zweiten und der dritten Elektrode entspricht.

3. Logikschaltkreis (100) gemäß Anspruch 2, wobei die erste und die dritte Elektrode jeweils einen Bias-Anschluss zum Anlegen des Bias-Signals tragen, welches ein Strom ist, und das Ausgangssignal eine Spannung ist, die zwischen den Messanschlüssen gemessen wird.

4. Logikschaltkreis (200) gemäß Anspruch 1, wobei das Muster aufweist:

- einen Stromaufwärts- (221) und einen Stromabwärts- (224) -Abschnitt, die jeweils durch ein Band gebildet sind, welches mit einem der Messanschlüsse in elektrischem Kontakt ist, und
- einen Zwischenabschnitt, der durch ein Band in Form einer Schleife gebildet ist, die einen oberen Zweig (223) und einen unteren Zweig (222) definiert,

wobei die erste Elektrode auf dem Stromaufwärts-Abschnitt, die zweite Elektrode auf dem unteren Zweig und die dritte Elektrode auf dem oberen Zweig angeordnet ist, wobei ein Pegel des Ausgangssignals zwischen den Messanschlüssen, die sich an den Enden des Musters befinden, einem logischen "UND" zwischen den Magnetisierungen der zweiten und der dritten Elektrode entspricht.

5. Logikschaltkreis (200) gemäß Anspruch 1, wobei das Muster aufweist:

- einen Stromaufwärts- (221) und einen Stromabwärts- (224) -Abschnitt, die jeweils durch ein Band gebildet sind, das mit einem der Messanschlüsse in elektrischem Kontakt ist, wobei eine erste Elektrode auf dem Stromaufwärts-Abschnitt stromabwärts von dem Messanschluss angeordnet ist, wobei eine Magnetisierung der ersten Elektrode einem Logikpegel C entspricht, und
- einen Zwischenabschnitt, der durch das parallele Schalten mehrerer Bänder gebildet ist, die jeweils Zweige definieren, wobei jeder Zweig durch eine ganze Zahl k identifiziert ist, einerseits mit dem Stromaufwärts-Abschnitt und andererseits mit dem Stromabwärts-Abschnitt verbunden ist und eine Elektrode trägt, wobei eine Magnetisierung davon einem Logikpegel Vk entspricht,

wobei ein Pegel des Ausgangssignals zwischen den Messanschlüssen, die sich an den Enden des Musters befinden, einer logischen Funktion $NOR(V_k==C)$ zwischen den Magnetisierungen der Elektroden entspricht.

6. Logikschaltkreis (200) gemäß einem der Ansprüche 4 oder 5, wobei das Ausgangssignal eine Spannung ist, die zwischen den Messanschlüssen (V+, V-) gemessen wird, und ein Polarisierungsstrom zwischen den Bias-Anschlüssen (I+, I-) angelegt wird, wobei ein erster Bias-Anschluss davon Teil des Stromaufwärts-Abschnitts stromaufwärts von der ersten Elektrode ist, und wobei ein zweiter Bias-Anschluss davon Teil des Stromabwärts-Abschnitts des Schaltkreises stromabwärts von den Elektroden ist.

7. Logikschaltkreis (100; 200; 300; 400) gemäß irgendeinem der Ansprüche 1 bis 5, wobei, wenn die Zwischenschicht durch einen Ausschnitt unterbrochen ist, das Ausgangssignal ein Strom ist, der einen Widerstand durchquert, der die Zwischenschicht auf beiden Seiten des Ausschnitts verbindet, und die Polarisierungsquelle eine Bias-Spannung ist, die zwischen den Bias-Anschlüssen angelegt wird, die sich an jedem der Enden des Musters befinden.

8. Logikschaltkreis (100; 200; 300; 400) gemäß irgendeinem der Ansprüche 1 bis 7, wobei das Supraleitermaterial der Supraleiterschichten jeder Elektrode ein Supraleitermaterial mit hoher kritischer Temperatur, vorzugsweise YBCO ist.

9. Logikschaltkreis (100; 200; 300; 400) gemäß Anspruch 8, wobei eine Dicke der Supraleiterschichten jeder Elektrode zwischen 20 und 40 nm, vorzugsweise 25 und 35 nm, vorzugweise ferner gleich 30 nm ausgewählt ist.

10. Logikschaltkreis (100; 200; 300; 400) gemäß irgendeinem der Ansprüche 1 bis 9, wobei das ferromagnetische Material der Polarisatoren (2, 4) jeder Elektrode LCMO ist.

11. Logikschaltkreis (100; 200; 300; 400) gemäß Anspruch 10, wobei eine Dicke der Polarisatoren jeder Elektrode zwischen 3 und 10 nm, vorzugsweise gleich 5 nm ausgewählt ist.

12. Logikschaltkreis (100; 200; 300; 400) gemäß irgendeinem der Ansprüche 1 bis 11, wobei das Material der Zwischenschicht ein Normalmetall ist, das aus Normalmetalloxiden oder Normalelementarmetallen ausgewählt ist.

13. Logikschaltkreis (100; 200; 300; 400) gemäß Anspruch 12, wobei eine Dicke der Zwischenschicht zwischen 15 und 25 nm, vorzugsweise gleich 20 nm ausgewählt ist.

14. Logikschaltkreis (100; 200; 300; 400) gemäß irgendeinem der Ansprüche 1 bis 13, wobei das Substrat aus einem Material realisiert ist, das aus Saphir und $SrTiO_3$ ausgewählt ist.

15. Logikschaltkreis gemäß irgendeinem der Ansprüche 1 bis 14, wobei eine Entfernung zwischen den Elektroden und eine Dicke der Polarisatoren der Elektroden von einer Kohärenzlänge ($L_N$) der Ladungsträger in der Zwischenschicht und einer Kohärenzlänge ($L_P$) der Ladungsträger in den Polarisatoren abhängen.

16. Schaltkreis, **dadurch gekennzeichnet, dass** er eine Mehrzahl von Logikschaltkreisen aufweist, wobei jedes Logikgatter einem Gatter gemäß irgendeinem der Ansprüche 1 bis 15 entspricht.

## Claims

1. A logic circuit (100; 200; 300; 400), **characterized in that** it includes:

   - an intermediate layer (103; 203; 303; 403), made from an electric current conducting material and configured according to a pattern;
   - a first electrode and a plurality of electrodes, which includes at least second and third electrodes (126, 127, 128; 226, 227, 228; 325, 326, 327, 328; 425, 426, 427, 428);

   each electrode including:

   ◦ A polarizer, made from a ferromagnetic material, placed at a particular point of the pattern of the intermediate layer, and having a magnetization,
   ◦ A superconducting layer, made from a superconducting material, arranged on a surface of the polarizer opposite a surface of the polarizer in contact with the intermediate layer;
   - at least one control means (112; 212; 312; 412) able to modify the magnetization of the polarizer of an electrode among the second and third electrodes;
   - at least one other control means (122; 232; 332; 432) able to modify the magnetization of the polarizer of the other electrode among the second and third electrodes;

   the first and second electrodes on the one hand, and the first and third electrodes on the other hand, making up two spin valves of the spin-polarized supercurrent type,

- bias terminals for applying a bias signal; and
- terminals for measuring an output signal,

a level of the output signal being correlated with a mutual orientation of the first, second and third magnetizations.

2. The logic circuit (100) according to claim 1, wherein, the pattern being a band, the first, second and third electrodes are successively arranged along the length of said band, arranging a space between them, and the measuring terminals are arranged at the ends of the band, on either side of the electrodes, the level of the output signal then corresponding to a logic "OR" between the magnetizations of the second and third electrodes, the first magnetization being fixed, or complementary to a logic "EQV" between the magnetization of the first, second and third electrodes.

3. The logic circuit (100) according to claim 2, wherein the first and third electrodes each bear a bias terminal for applying the bias signal, which is a current, and the output signal is a voltage measured across the measuring terminals.

4. The logic circuit (200) according to claim 1, wherein the pattern includes:

- upstream (221) and downstream (224) portions each made up of a band that is in electrical contact with one of the measuring terminals; and
- an intermediate portion made up of a loop-shaped band defining an upper branch (223) and a lower branch (222),

the first electrode being placed on the upstream portion, the second electrode on the lower branch, and the third electrode on the upper branch, an output signal level taken across the measuring terminals situated at the ends of the pattern corresponds to a logic "AND" between the magnetizations of the second and third electrodes.

5. The logic circuit (200) according to claim 1, wherein the pattern includes:

- upstream (221) and downstream (224) portions each made up of a band that is in electrical contact with one of the measuring terminals, a first electrode being placed on the upstream portion downstream from the measuring terminal, a magnetization of the first electrode corresponding to a logic level C; and
- an intermediate portion made up by the placement in electrical parallel of several bands each defining branches, each branch being identified by an integer k, being connected on the one hand to the upstream portion and on the other hand to the downstream portion and bearing an electrode, including a magnetization corresponding to a logic level Vk,

an output signal level taken across the measuring terminals situated at the ends of the pattern corresponds to a logic function $NOR(V_k==C)$ between the magnetizations of the electrodes.

6. The logic circuit (200) according to one of claims 4 or 5, wherein the output signal is a voltage measured across the measuring terminals (V+, V-), and a polarization current is applied between the bias terminals (I+, I-), whereof a first bias terminal is part of the upstream portion, upstream from the first electrode, and whereof a second bias terminal is part of the downstream portion of the circuit, downstream from the electrodes;

7. The logic circuit (100; 200; 300; 400) according to any one of claims 1 to 5, the intermediate layer being interrupted by a cutout, the output signal is a current traversing a resistance connecting the intermediate layer on either side of the cutout, and the polarization source being a bias voltage applied across the bias terminals situated at each of the ends of the pattern.

8. The logic circuit (100; 200; 300; 400) according to any one of claims 1 to 7, wherein the superconducting material of the superconducting layers of each electrode is a superconducting material with a high critical temperature, preferably YBCO.

9. The logic circuit (100; 200; 300; 400) according to claim 8, wherein a thickness of the superconducting layers of each electrode is chosen between 20 and 40 nm, preferably 25 and 35 nm, still more preferably equal to 30 nm.

10. The logic circuit (100; 200; 300; 400) according to any one of claims 1 to 9, wherein the ferromagnetic material of the polarizers (2, 4) of each electrode is LCMO.

**11.** The logic circuit (100; 200; 300; 400) according to claim 10, wherein a thickness of the polarizers of each electrode is chosen between 3 and 10 nm, preferably equal to 5 nm.

**12.** The logic circuit (100; 200; 300; 400) according to any one of claims 1 to 11, wherein the material of the intermediate layer is a normal metal, chosen from among normal metal oxides or elementary normal metals.

**13.** The logic circuit (100; 200; 300; 400) according to claim 12, wherein a thickness of the intermediate layer is chosen between 15 and 25 nm, preferably equal to 20 nm.

**14.** The logic circuit (100; 200; 300; 400) according to any one of claims 1 to 13, wherein the substrate is made from a material chosen from among sapphire and $SrTiO_3$.

**15.** The logic circuit according to any one of claims 1 to 14, wherein a distance between the electrodes and a thickness of the polarizers of the electrodes depends on the coherence length ($L_N$) of the charge carriers in the intermediate layer and a coherence length ($L_P$) of the charge carriers in the polarizers.

**16.** A circuit, **characterized in that** it comprises a plurality of logic circuits, each logic circuit corresponding to a logic circuit according to any one of claims 1 to 15.

## FIG.1

## FIG.2

## FIG.3

## FIG.4

## FIG.5

## FIG.10

## FIG.11

## FIG.6

## FIG.7a

226'

245'    201'

227'                    I+

I-              V+    202'

204'                    M226

203'              M227  V-    228'

220'                      M228

212'                    234'          232'

## FIG.7b

300        325      328        332

I+  V+          327

326

321                      323

320    322              303    324

V-    I-

312

## FIG.8

## FIG.9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Andreev reflection: A new means to determine the spin polarization of ferromagnetic materials. **SOULEN R J et al.** JOURNAL OF APPLIED PHYSICS. AMERICAN INSTITUTE OF PHYSICS, 15 Avril 1999, vol. 85, 4589-4591

- Andreev reflection: A new means to determine the spin polarization of ferromagnetic materials. **SOULEN R.J. et al.** JOURNAL OF APPLIED PHYSICS. AMERICAN INSTITUTE OF PHYSICS, 15 Avril 1999, vol. 85, 4589-4591
- **T.M. KLAPWIJK.** Proximity effect from an Andreev perspective. *Journal of Superconductivity: Incorporating Novel Magnetism,* Octobre 2004, vol. 17 (5